# EUROPEAN PATENT SPECIFICATION

(11) **EP 3 423 948 B1**
(45) Date of publication and mention of the grant of the patent: **15.12.2021**
(21) Application number: 17760423.8
(22) Date of filing: 16.01.2017
(51) Int. Cl.: G06F 13/16, G11C 7/10, G11C 7/22, G11C 11/4076

(54) **TECHNIQUES TO CAUSE A CONTENT PATTERN TO BE STORED TO MEMORY CELLS OF A MEMORY DEVICE**
TECHNIKEN, UM ZU BEWIRKEN, DASS EIN INHALTSMUSTER IN SPEICHERZELLEN EINER SPEICHERVORRICHTUNG GESPEICHERT WIRD
TECHNIQUES POUR PROVOQUER LE STOCKAGE D'UN MOTIF DE CONTENU DANS DES CELLULES DE MÉMOIRE D'UN DISPOSITIF DE MÉMOIRE

(30) Priority: 04.03.2016 US 201662303688 P; 27.09.2016 US 201615277159
(43) Date of publication of application: 09.01.2019
(73) Proprietor: Intel Corporation, Santa Clara, CA 95054 (US)
(72) Inventor: COX, Christopher, E., Placerville, CA 95667 (US); BAINS, Kuljit, S., Olympia, WA 98516 (US); MCCALL, James, A., Portland, OR 97229 (US)
(74) Representative: Rummler, Felix
(86) International application number: PCT/US2017/013655
(87) International publication number: WO 2017/151227

(56) References cited:
- EP-A2- 2 085 867
- WO-A1-2009/117251
- US-A1- 2002 118 882
- US-A1- 2011 289 270
- US-A1- 2011 289 270
- US-A1- 2014 032 830
- US-A1- 2015 012 694
- US-A1- 2015 286 406

## Description

### RELATED CASE

This application claims priority to US Application No. 15/277,159 filed on September 27, 2016, entitled TECHNIQUES TO CAUSE A CONTENT PATTERN TO BE STORED TO MEMORY CELLS OF A MEMORY DEVICE which in turn claims the benefit of priority of U.S. Provisional Application Serial No. 62/303,688, filed on March 4, 2016 entitled TECHNIQUES TO CAUSE A PATTERN TO BE STORED TO MEMORY CELLS OF A MEMORY DEVICE.

### TECHNICAL FIELD

Examples described herein are generally related to techniques for write operations to a memory device.

### BACKGROUND

In some memory systems "killer patterns" may be identified for data content to be stored to memory cells of memory devices. These killer patterns may result in conditions where a pattern transmitted on a data bus generates worst case margins due to power delivery or memory channel characteristics. These killer patterns may originate from various applications storing data to memory devices in patterns of repeating sequences that may include large numbers of consecutively repeating values of "1" or "0" being stored to the memory devices through the data bus. Package resonance may result and this package resonance may potentially cause a worst case margin.

WO 2009/117251 A1 relates to the operation of a flash memory system. The flash memory system receives write data and a corresponding logical address. The system then determines whether the write data matches a predetermined data pattern. If the write data does match the predetermined data pattern, instead of writing the data, the system records an indication that the predetermined data pattern corresponds to the logical address.

EP 2 085 867 A2 describes a storage subsystem having a virtual volume and a page volume which has a page physical area allocated to the virtual volume. The storage subsystem divides an address space of the virtual volume into a plurality of pages, classifies each of the pages into one of a plurality of states including at least a first state and a second state, and further divides a page which is classified into the second state into a plurality of segments to manage the page classified into the second state. The first state is a state in which a page physical area is allocated to the page from the page volume, and the write data is stored in the page physical area. The second state is a state in which the predetermined pattern data and the segment are managed, in the memory, by correlating with each other.

US 2011/289270 A1 relates to managing data transfer. A processor unit compares data to be written to a memory system to a stored data pattern. Responsive to determining that the data matches the stored data pattern, the matching data is replaced with a pattern tag corresponding to the matching data pattern. The pattern tag is then transmitted to the memory system.

### SUMMARY OF INVENTION

The invention is defined by a memory device according to claim 1 and by a method of storing a content pattern to said memory device according to claim 5.

### BRIEF DESCRIPTION OF THE DRAWINGS

**FIG. 1** illustrates an example first memory device.
**FIG. 2** illustrates an example second memory device.
**FIG. 3** illustrates an example timing diagram.
**FIG. 4** illustrates an example memory die image.
**FIG. 5** illustrates an example pattern table.
**FIG. 6** illustrates an example block diagram for an apparatus.
**FIG. 7** illustrates an example of a logic flow.
**FIG. 8** illustrates an example of a storage medium.
**FIG. 9** illustrates an example computing platform.

### DETAILED DESCRIPTION

As contemplated in the present disclosure, killer patterns may originate from various applications storing data to memory devices in patterns of repeating sequences that may include large numbers of consecutively repeating values of "1" or "0" being stored to the memory devices through the data bus. Some existing solutions utilize scrambling techniques that tend to reduce the possibility that negative effects such as package resonance may occur. However, common patterns may still be problematic for a memory interface that may have inherent idle to active conditions. For example, even though a system may be in an idle or low power state, an application may send periodic status updates or snoops that include common patterns having large numbers of consecutively repeating values of "1" or "0". Scrambling techniques may not be effective for consecutively repeating values of "1" or "0" in these inherent idle to active conditions. It is with respect to the above-mentioned and other challenges that the examples described herein are needed.

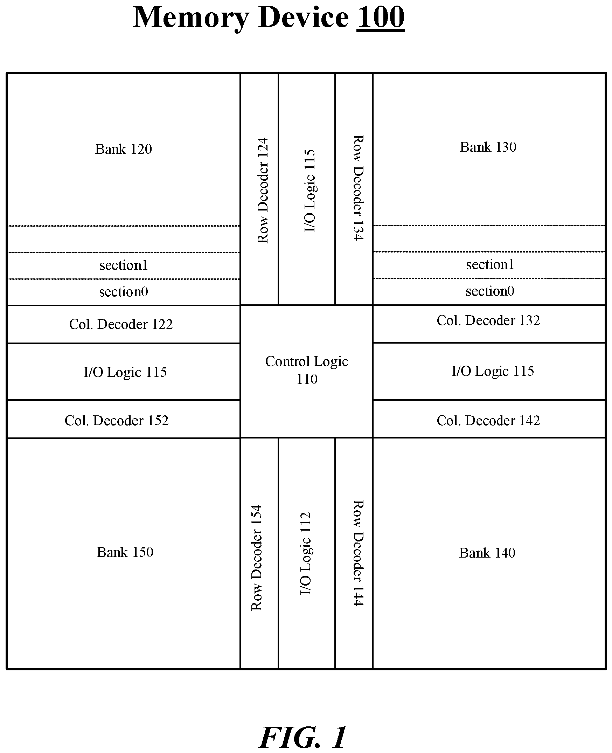

**FIG. 1** illustrates an example memory device 100. In some examples, memory device 100 may be thought of as an array of memory bit cells organized in a two-dimensional fashion for a memory device. In order to access information, an address vector may be given to the memory device and a block of information may be retrieved. The array of memory bit cells may be divided into somewhat independent banks that are shown in FIG. 1 as banks 120, 130, 140 or 150. Bank address bits in the address vector may be used to select a bank from among banks 120, 130, 140 or 150. A given bank may be further divided into many sections. Access to the banks and their respective sections may be facilitated by logic, features and/or circuitry that may include a control logic 110 and various other logic, features and/or circuitry shown in FIG. 1 such as input/output (I/O) logic 115, column (col.) decoders 122, 132, 142 and 152 or row decoders 124, 134, 144 and 154.

In some examples, sections of a same bank may share peripheral logic, features and/or circuitry. For example, section0 and section1 of bank 120 may share I/O logic 115, col. decoder 122, row decoder 124 and logic 115. According to some examples, at a given time only one section may be allowed to be active. A section may be further divided into many tiles (not shown) sometimes called sub-arrays. Address bits other than bank address bits in an address vector may be row address bits and column address bits. Row address bits may be used to select a section and a row within the selected section. A row in a section may have an equivalent of 16K to 64K bits (or 2K to 8K bytes) in a row. A row, in some examples, may also be called a page or memory page. Each bit in a row may have a corresponding sense amplifier (amp) which may be used to access content maintained in bit cells.

According to some examples, memory device 100 may include a type of volatile memory such as, but not limited to, dynamic random access memory (DRAM). For these examples, DRAM bit cells may store information or content in a capacitor. Sense amps for each bit cell may be sensed through phases. First, a bit-line (and its complement) needs to be pre-charged to a certain voltage. Then a row may be enabled after a row address has been decoded. Charge (or lack of charge) in a bit cell may then be shared with the bit-line resulting in a small difference in voltage between the bit-line and its complement. At this time the sense amp may be enabled to amplify the voltage difference to determine content in the bit cell. Data stored in sense amps may then be further selected using a column address decoded from column address bits to go out of memory device 100 through I/O pins (not shown). Typically, a DRAM device may have 4 to 32 pins for data I/O. The above actions may be initiated by a command and performed by the logic, features and/or circuitry mentioned above for memory device 100.

In some examples, a memory device 100 including DRAM memory may be arranged to operate according to various developed memory technologies that may include, but are not limited to, DDR4 (double data rate (DDR) version 4, initial specification published in September 2012 by JEDEC), LPDDR4 (LOW POWER DOUBLE DATA RATE (LPDDR) version 4, JESD209-4, originally published by JEDEC in August 2014), WIO2 (Wide I/O 2 (WideIO2), JESD229-2, originally published by JEDEC in August 2014), HBM (HIGH BANDWIDTH MEMORY DRAM, JESD235, originally published by JEDEC in October 2013), and/or other technologies based on derivatives or extensions of such specifications. Memory device 100 including DRAM memory may also be arranged to operate according to various memory technologies currently in development that may include, but are not limited to, DDR5 (DDR version 5, currently in discussion by JEDEC), LPDDR5 (LPDDR version 5, currently in discussion by JEDEC), HBM2 (HBM version 2, currently in discussion by JEDEC), and/or other new technologies based on derivatives or extensions of such specifications. For each of these developed or developing technologies and/or specifications, commands may be coded using such command bits as row address strobe (RAS#), column address strobe (CAS#) or write enable (WE#) to name a few.

In some examples, as briefly mentioned above, and described more below, a new command may be introduced or added to the various DRAM technologies or specifications to cause a pattern of data content programmed or stored to a register (e.g., a pattern register) at a memory device to be stored to at least a portion of memory cells of the memory device without actually sending data across the data or DQ bus. This single command may be referred to as a Write pattern activate (WPACT) Command. The pattern of data content may be preprogrammed to the register and the pattern may be defined as all zeros or may be some other predefined pattern. The pattern may run across both a width of memory device 100 and along a length of memory device 100 for a burst length (BL) associated with a single read command received via a command/address bus coupled with memory device 100 (not shown).

Although example types of memory included in memory device 100 have been described as including volatile types of memory such as DRAM, this disclosure is not limited to DRAM. In some examples, other volatile types of memory including, but not limited to, double data rate synchronous dynamic RAM (DDR SDRAM), static random-access memory (SRAM), Thyristor RAM (T-RAM) or zero-capacitor RAM (Z-RAM) are contemplated by this disclosure. Also, block addressable non-volatile types of memory, such as those associated with NAND or NOR technologies are contemplated by this disclosure. Also, other non-volatile types of memory such as 3-D cross-point memory that are byte addressable are contemplated by this disclosure. These block addressable or byte addressable non-volatile types of memory may include, but are not limited to, non-volatile types of memory that use chalcogenide phase change material (e.g., chalcogenide glass), multi-threshold level NAND flash memory, NOR flash memory, single or multi-level phase change memory (PCM), resistive memory, nanowire memory, ferroelectric transistor random access memory (FeTRAM), magnetoresistive random access memory (MRAM) memory that incorporates memristor technology, or spin transfer torque MRAM (STT-MRAM), or a combination of any of the above, or other non-volatile memory types.

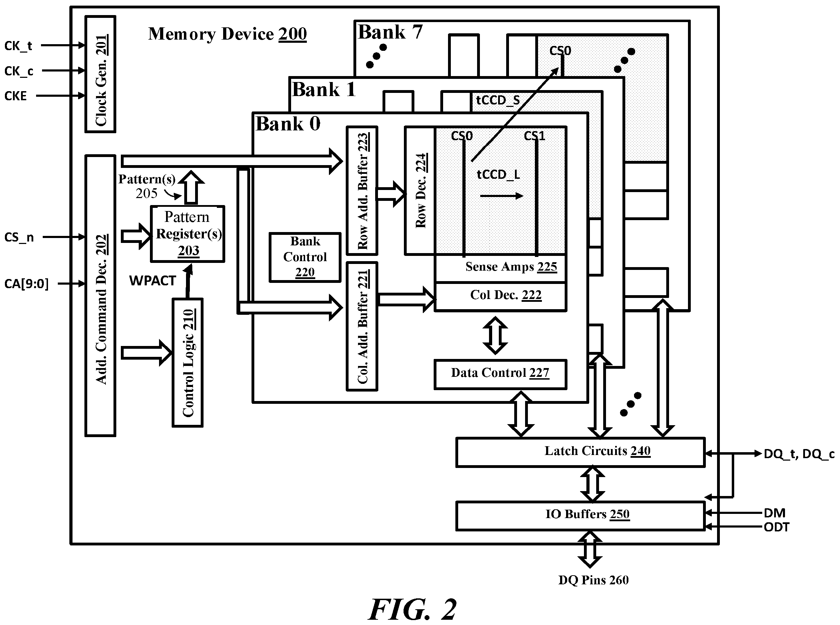

**FIG. 2** illustrates an example memory device 200. In some examples, as shown in FIG. 2, memory device 200 includes various logic, features or circuits to access banks 0 to 7 responsive to received commands. For example, memory device 200 may include peripheral circuitry to access banks 0-7 that includes a clock generator 201, an address command decoder 202, one or more pattern register(s) 203, a control logic 210, latch circuits 240, IO buffers 250 or DQ pins 260. Also, each bank of banks 0 to 7 may separately include a bank control 220, a row address buffer 223, a column address buffer 221, a row decoder 224, sense amps 225, a column decoder 222 or data control 227.

According to some examples, control logic 210 may include logic and/or features capable of generating or forwarding a WPACT command to cause a pattern to be pulled from pattern register(s) 203 and place the pattern in memory cells of one or more banks included in banks 0 to 7. For these examples, a single command such as WPACT may have been received via address command decoder 202 and may be recognized by control logic 210 of memory device 200 to cause one or more pattern(s) 205 to be stored in memory cells of bank 0 through column address buffer 221 and row address buffer 223. This is done without sending data through DQ pins 260.

In some examples, pattern register(s) 203 may include a first register that includes a pattern of all "0" values and a second register that includes a pattern of all "1" values. Values of both all "0" and all "1" typically cause worst case power delivery scenarios. So removing the need to transmit these types of patterns through DQ pins 260 may be beneficial to memory device 200.

According to some examples, dynamically determined content patterns may be used to reduce effects of victim bits or other issues caused by repeated patterns to memory cells. For these examples, run-time information for write requests to memory device 200 over fixed or variable time intervals may be evaluated to determine patterns and these dynamically determined patterns may result in various different content patterns being stored to pattern register(s) 203. As a result, pattern register(s) 203 may be based on these determined patterns and may be occasionally re-programmed or updated (e.g., similar to reprograming or updating a mode register).

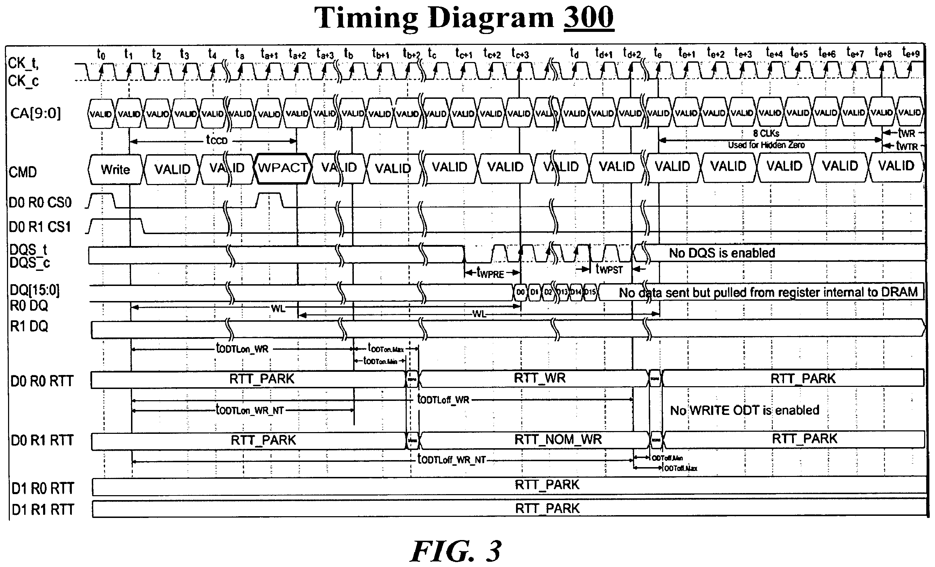

**FIG. 3** illustrates an example timing diagram 300. In some examples, timing diagram 300 as shown in FIG. 3 depicts timing for ranks R0 and R1 of memory devices D0 and D 1 responsive to receiving a normal Write command followed by a WPACT command. As mentioned previously for FIG. 2, a WPACT command may have been forwarded to these memory devices to cause a pattern stored in a register to be stored to memory cells of a given memory device. At least some elements of memory device 200 shown in FIG. 2 may be used to describe internal actions taken in response to the WPACT command. Examples are not limited to elements of memory device 200 for timing diagram 300.

According to some examples, timing diagram 300 shows a Write command on the command (CMD) bus that is directed to memory device D0 and rank 0 (D0 RO CS0). On die termination (ODT) is turned on to receive data via R0 DQ. Timing diagram 300 then shows that the Write command is followed with a WPACT command at time ta. The WPACT command is targeted to the same memory device D0 and rank 0. After data is received from the previous Write command, the ODT for both D0 R0 and D0 R1 may be disabled or turned off at time te. At this point, data is no longer received via R0 or R1 DQs. The pattern maintained in pattern register(s) 203 may then be pulled and stored to a least a portion of memory cells of D0 R0.

In some examples, use of the WPACT command may also save que space for a command que as the WPACT may be sent and the que may then be dumped.

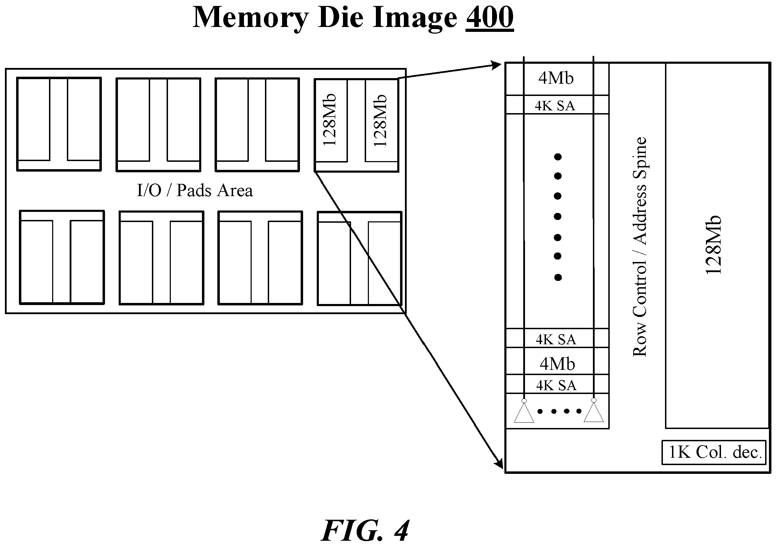

**FIG. 4** illustrates an example memory die image 400. In some examples, memory die image 400 may be a 2 gigabit (Gb) DRAM die image. The blown up portion of memory die image 400 indicates how logic (e.g., control logic 210) and a register (e.g. pattern register(s) 203) may be embedded in a column decoder (col. Dec.) area that may be just outside of each 123Mb block array.

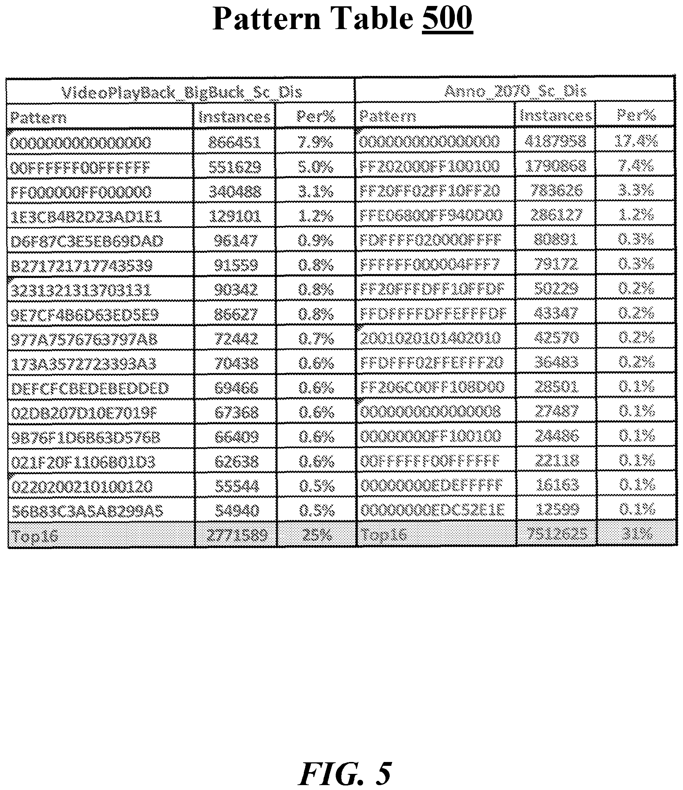

**FIG. 5** illustrates an example pattern table 500. In some examples, pattern table 500 indicates repeating patterns from types of video playback workloads. As shown in pattern table 500, the top 16 repeating patterns may be composed of 25% for

VideoPlayBack_BigBuck_Sc_Dis and 31% for Anno_2070_Sc_Dis. Also, as shown in FIG. 5, repeating patterns having values of all zeros are indicated as being 7.9% and 17.4% for VideoPlayBack BigBuck_Sc_Dis and Anno_2070_Sc_Dis, respectively for each of these video playback workload's top 16 repeating patterns. As mentioned previously, all zero's may form or cause a worst case power delivery scenario if this type of pattern is repeatedly transmitted through a memory device's data bus (e.g., through DQ pins).

According to some examples, logic and/or features of a controller for a memory device used to service these video playback workloads may have already stored all zero content patterns to registers maintained at the memory device. Negative impacts of all zero's through a memory device's data bus may be mitigated via the controller generating a WPACT command responsive to recognizing an all zero video playback workload to prevent an all zero pattern from being repeatedly transmitted through the memory device's data bus. In the case of the Anno-2070_Sc_Dis video playback workload, 17.4% of the workload could be handled via WPACT commands.

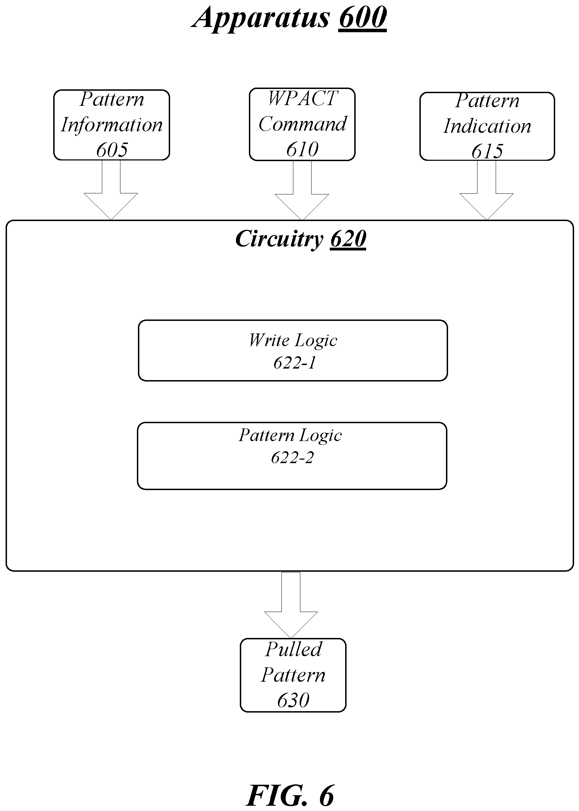

**FIG. 6** illustrates an example block diagram for an apparatus 600. Although apparatus 600 shown in FIG. 6 has a limited number of elements in a certain topology, it may be appreciated that the apparatus 600 may include more or less elements in alternate topologies as desired for a given implementation.

The apparatus 600 may be supported by circuitry 620 and apparatus 600 may be a controller or controller logic maintained at a memory device or memory system. The memory device may be coupled to a host computing platform. Circuitry 620 may be arranged to execute one or more software or firmware implemented components, modules or logic 622-*a* (e.g., implemented, at least in part, by a storage controller of a storage device). It is worthy to note that "*a*" and "*b*" and "c" and similar designators as used herein are intended to be variables representing any positive integer. Thus, for example, if an implementation sets a value for *a* = 2, then a complete set of software or firmware for logic, components or modules 622-*a* may include logic 622-1 or 622-2. Also, at least a portion of "logic" may be software/firmware stored in computer-readable media, and although the logic is shown in FIG. 6 as discrete boxes, this does not limit logic to storage in distinct computer-readable media components (e.g., a separate memory, etc.).

According to some examples, circuitry 620 may include a processor or processor circuitry. The processor or processor circuitry can be any of various commercially available processors, including without limitation an AMD^{®} Athlon^{®}, Duron^{®} and Opteron^{®} processors; ARM^{®} application, embedded and secure processors; IBM^{®} and Motorola^{®} DragonBall^{®} and PowerPC^{®} processors; IBM and Sony^{®} Cell processors; Intel^{®} Atom^{®}, Celeron^{®}, Core (2) Duo^{®}, Core i3, Core i5, Core i7, Itanium^{®}, Pentium^{®}, Xeon^{®}, Xeon Phi^{®} and XScale^{®} processors; and similar processors. According to some examples circuitry 620 may also include one or more application-specific integrated circuits (ASICs) and at least some logic 622-a may be implemented as hardware elements of these ASICs. In some examples, circuitry 620 may also include a field programmable gate array (FPGA) and at least some logic 622-a may be implemented as hardware elements of the FPGA.

According to some examples, apparatus 600 may include a write logic 622-1. Write logic 622-1 may be a logic and/or feature executed by circuitry 620 to determine a content pattern based on run-time information for write requests to a memory device over one or more time intervals. For these examples, pattern information 605 may include run-time information gathered over the one or more time intervals. Write logic 622-1 may forward content patterns to the memory device for storage to registers maintained at the memory device (e.g., pattern registers).

In some examples, apparatus 600 may also include a pattern logic 622-2. Pattern logic 622-2 may be a logic and/or feature executed by circuitry 620 to generate a command responsive to a write request to the memory device that includes at least one content pattern matching a content pattern included in the one or more patterns and forward the command to the memory device to cause the matching content pattern to be stored to at least a portion of memory cells for the memory device. For these examples, the generated and forwarded command may be a WPACT command included in WPACT command 610. The at least one content pattern matching the content pattern included in the one or more patterns may be included pattern indication 615. Pattern indication 615 may have been caused by an application executing at a host computing device or platform coupled with a memory device or system that includes apparatus 600. Pulled pattern 630 may include the matching content pattern that may be pulled from the registers at the memory device and stored to at least a portion of memory cells for the memory device.

Included herein is a set of logic flows representative of example methodologies for performing novel aspects of the disclosed architecture. While, for purposes of simplicity of explanation, the one or more methodologies shown herein are shown and described as a series of acts, those skilled in the art will understand and appreciate that the methodologies are not limited by the order of acts. Some acts may, in accordance therewith, occur in a different order and/or concurrently with other acts from that shown and described herein. For example, those skilled in the art will understand and appreciate that a methodology could alternatively be represented as a series of interrelated states or events, such as in a state diagram. Moreover, not all acts illustrated in a methodology may be required for a novel implementation.

A logic flow may be implemented in software, firmware, and/or hardware. In software and firmware embodiments, a logic flow may be implemented by computer executable instructions stored on at least one non-transitory computer readable medium or machine readable medium, such as an optical, magnetic or semiconductor storage. The embodiments are not limited in this context.

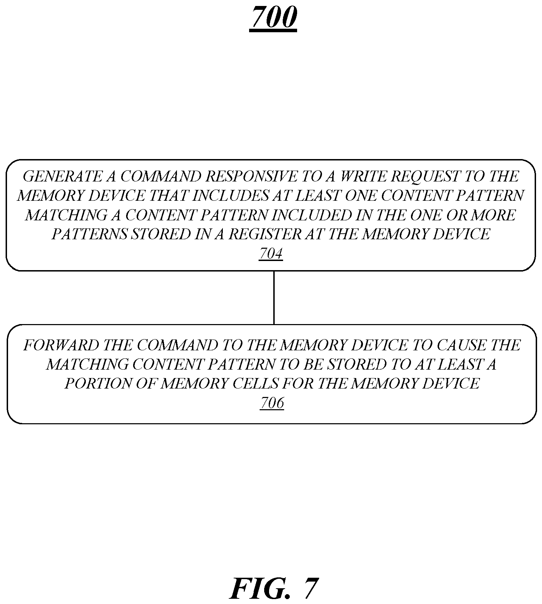

**FIG. 7** illustrates an example of a logic flow 700. Logic flow 700 may be representative of some or all of the operations executed by one or more logic, features, or devices described herein, such as apparatus 600. More particularly, logic flow 700 may be implemented by one or more of write logic 622-1 or pattern logic 622-2.

According to some examples, logic flow 700 at block 704 may generate a command responsive to a write request to the memory device that includes at least one content pattern matching a content pattern included in the one or more patterns stored in a register at the memory device. For these examples, pattern logic 622-2 may generate the command.

According to some examples, logic flow 700 at block 706 may forward the command to the memory device to cause the matching content pattern to be stored to at least a portion of memory cells for the memory device. For these examples, pattern logic 622-2 may forward the command.

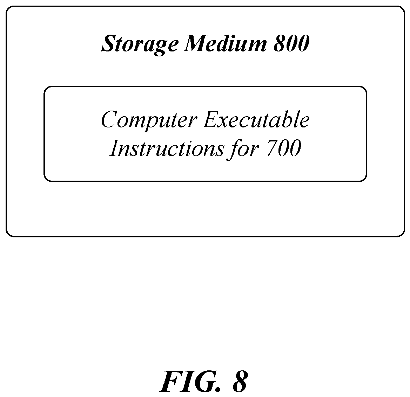

**FIG. 8** illustrates an example of a first storage medium. As shown in FIG. 8, the first storage medium includes a storage medium 800. The storage medium 800 may comprise an article of manufacture. In some examples, storage medium 800 may include any non-transitory computer readable medium or machine readable medium, such as an optical, magnetic or semiconductor storage. Storage medium 800 may store various types of computer executable instructions, such as instructions to implement logic flow 700. Examples of a computer readable or machine readable storage medium may include any tangible media capable of storing electronic data, including volatile memory or non-volatile memory, removable or non-removable memory, erasable or non-erasable memory, writeable or re-writeable memory, and so forth. Examples of computer executable instructions may include any suitable type of code, such as source code, compiled code, interpreted code, executable code, static code, dynamic code, object-oriented code, visual code, and the like. The examples are not limited in this context.

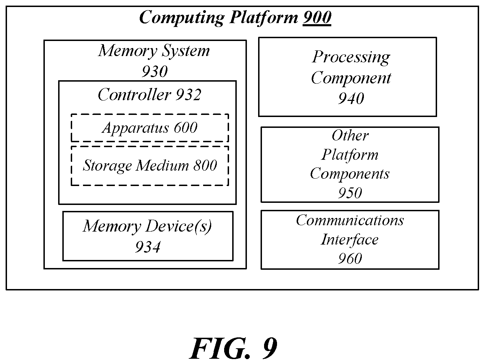

**FIG. 9** illustrates an example computing platform 900. In some examples, as shown in FIG. 9, computing platform 900 may include a memory system 930, a processing component 940, other platform components 950 or a communications interface 960. According to some examples, computing platform 900 may be implemented in a computing device.

According to some examples, memory system 930 may include a controller 932 and memory devices(s) 934. For these examples, logic and/or features resident at or located at controller 932 may execute at least some processing operations or logic for apparatus 600 and may include storage media that includes storage medium 800. Also, memory device(s) 934 may include similar types of volatile or non-volatile memory (not shown) that are described above for memory devices 100 or 200 shown in FIGS. 1 and 2. In some examples, controller 932 may be part of a same die with memory device(s) 934. In other examples, controller 932 and memory device(s) 934 may be located on a same die or integrated circuit with a processor (e.g., included in processing component 940). In yet other examples, controller 932 may be in a separate die or integrated circuit coupled with memory device(s) 934.

According to some examples, processing component 940 may include various hardware elements, software elements, or a combination of both. Examples of hardware elements may include devices, logic devices, components, processors, microprocessors, circuits, processor circuits, circuit elements (e.g., transistors, resistors, capacitors, inductors, and so forth), integrated circuits, ASIC, programmable logic devices (PLD), digital signal processors (DSP), FPGA/programmable logic, memory units, logic gates, registers, semiconductor device, chips, microchips, chip sets, and so forth. Examples of software elements may include software components, programs, applications, computer programs, application programs, system programs, software development programs, machine programs, operating system software, middleware, firmware, software modules, routines, subroutines, functions, methods, procedures, software interfaces, APIs, instruction sets, computing code, computer code, code segments, computer code segments, words, values, symbols, or any combination thereof. Determining whether an example is implemented using hardware elements and/or software elements may vary in accordance with any number of factors, such as desired computational rate, power levels, heat tolerances, processing cycle budget, input data rates, output data rates, memory resources, data bus speeds and other design or performance constraints, as desired for a given example.

In some examples, other platform components 950 may include common computing elements, such as one or more processors, multi-core processors, co-processors, memory units, chipsets, controllers, peripherals, interfaces, oscillators, timing devices, video cards, audio cards, multimedia I/O components (e.g., digital displays), power supplies, and so forth. Examples of memory units associated with either other platform components 950 or storage system 930 may include without limitation, various types of computer readable and machine readable storage media in the form of one or more higher speed memory units, such as read-only memory (ROM), RAM, DRAM, DDR DRAM, synchronous DRAM (SDRAM), DDR SDRAM, SRAM, programmable ROM (PROM), EPROM, EEPROM, flash memory, ferroelectric memory, SONOS memory, polymer memory such as ferroelectric polymer memory, nanowire, FeTRAM or FeRAM, ovonic memory, phase change memory, memristers, STT-MRAM, magnetic or optical cards, and any other type of storage media suitable for storing information.

In some examples, communications interface 960 may include logic and/or features to support a communication interface. For these examples, communications interface 960 may include one or more communication interfaces that operate according to various communication protocols or standards to communicate over direct or network communication links. Direct communications may occur through a direct interface via use of communication protocols or standards described in one or more industry standards (including progenies and variants) such as those associated with the SMBus specification, the PCIe specification, the NVMe specification, the SATA specification, SAS specification or the USB specification. Network communications may occur through a network interface via use of communication protocols or standards such as those described in one or more Ethernet standards promulgated by the IEEE. For example, one such Ethernet standard may include IEEE 802.3-2012, Carrier sense Multiple access with Collision Detection (CSMA/CD) Access Method and Physical Layer Specifications, Published in December 2012 (hereinafter "IEEE 802.3").

Computing platform 900 may be part of a computing device that may be, for example, user equipment, a computer, a personal computer (PC), a desktop computer, a laptop computer, a notebook computer, a netbook computer, a tablet, a smart phone, embedded electronics, a gaming console, a server, a server array or server farm, a web server, a network server, an Internet server, a work station, a mini-computer, a main frame computer, a supercomputer, a network appliance, a web appliance, a distributed computing system, multiprocessor systems, processor-based systems, or combination thereof. Accordingly, functions and/or specific configurations of computing platform 900 described herein, may be included or omitted in various embodiments of computing platform 900, as suitably desired.

The components and features of computing platform 900 may be implemented using any combination of discrete circuitry, ASICs, logic gates and/or single chip architectures. Further, the features of computing platform 900 may be implemented using microcontrollers, programmable logic arrays and/or microprocessors or any combination of the foregoing where suitably appropriate. It is noted that hardware, firmware and/or software elements may be collectively or individually referred to herein as "logic", "circuit" or "circuitry."

One or more aspects of at least one example may be implemented by representative instructions stored on at least one machine-readable medium which represents various logic within the processor, which when read by a machine, computing device or system causes the machine, computing device or system to fabricate logic to perform the techniques described herein. Such representations may be stored on a tangible, machine readable medium and supplied to various customers or manufacturing facilities to load into the fabrication machines that actually make the logic or processor.

Various examples may be implemented using hardware elements, software elements, or a combination of both. In some examples, hardware elements may include devices, components, processors, microprocessors, circuits, circuit elements (e.g., transistors, resistors, capacitors, inductors, and so forth), integrated circuits, ASICs, PLDs, DSPs, FPGAs, memory units, logic gates, registers, semiconductor device, chips, microchips, chip sets, and so forth. In some examples, software elements may include software components, programs, applications, computer programs, application programs, system programs, machine programs, operating system software, middleware, firmware, software modules, routines, subroutines, functions, methods, procedures, software interfaces, APIs, instruction sets, computing code, computer code, code segments, computer code segments, words, values, symbols, or any combination thereof. Determining whether an example is implemented using hardware elements and/or software elements may vary in accordance with any number of factors, such as desired computational rate, power levels, heat tolerances, processing cycle budget, input data rates, output data rates, memory resources, data bus speeds and other design or performance constraints, as desired for a given implementation.

Some examples may include an article of manufacture or at least one computer-readable medium. A computer-readable medium may include a non-transitory storage medium to store logic. In some examples, the non-transitory storage medium may include one or more types of computer-readable storage media capable of storing electronic data, including volatile memory or non-volatile memory, removable or non-removable memory, erasable or non-erasable memory, writeable or re-writeable memory, and so forth. In some examples, the logic may include various software elements, such as software components, programs, applications, computer programs, application programs, system programs, machine programs, operating system software, middleware, firmware, software modules, routines, subroutines, functions, methods, procedures, software interfaces, API, instruction sets, computing code, computer code, code segments, computer code segments, words, values, symbols, or any combination thereof.

According to some examples, a computer-readable medium may include a non-transitory storage medium to store or maintain instructions that when executed by a machine, computing device or system, cause the machine, computing device or system to perform methods and/or operations in accordance with the described examples. The instructions may include any suitable type of code, such as source code, compiled code, interpreted code, executable code, static code, dynamic code, and the like. The instructions may be implemented according to a predefined computer language, manner or syntax, for instructing a machine, computing device or system to perform a certain function. The instructions may be implemented using any suitable high-level, low-level, object-oriented, visual, compiled and/or interpreted programming language.

Some examples may be described using the expression "in one example" or "an example" along with their derivatives. These terms mean that a particular feature, structure, or characteristic described in connection with the example is included in at least one example. The appearances of the phrase "in one example" in various places in the specification are not necessarily all referring to the same example.

Some examples may be described using the expression "coupled" and "connected" along with their derivatives. These terms are not necessarily intended as synonyms for each other. For example, descriptions using the terms "connected" and/or "coupled" may indicate that two or more elements are in direct physical or electrical contact with each other. The term "coupled," however, may also mean that two or more elements are not in direct contact with each other, but yet still co-operate or interact with each other. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

## Claims

1. A memory device comprising:
an array of memory bit cells organized in a two-dimensional fashion, the array of memory bit cells being divided into banks ;
a pattern register (203); and
a controller for the memory device (200; 934) that includes logic (210; 622-2), at least a portion of which comprises hardware, the logic (210; 622-2) configured to:
generate a command responsive to a write request to the memory device (200; 934) that includes at least one content pattern matching a content pattern stored in the pattern register (203) at the memory device (200; 934), wherein the command comprises a write pattern activate, WPACT, command and the matching content pattern (630) includes large numbers of consecutively repeating bit values of 1 or 0; and
forward the WPACT command to the memory device (200; 934) to cause the matching content pattern (630) to be pulled from the pattern register (203) and stored to at least a portion of the memory bit cells of the memory device (200; 934).

2. The memory device of claim 1, wherein the logic (210; 622-2) is further configured to:
determine the one or more content patterns based on run-time information for write requests to the memory device (200; 934) over a first time interval.

3. The memory device of claim 2, wherein the logic (210; 622-2) is further configured to:
determine one or more second content patterns based on run-time information for write requests to the memory device (200; 934) over a second time interval; and
forward the one or more second content patterns to the memory device (200; 934) for storage to registers (203) maintained at the memory device (200; 934).

4. The memory device of claim 1, wherein the memory device (200; 934) includes non-volatile memory or volatile memory, wherein the volatile memory includes dynamic random access memory (DRAM) and the non-volatile memory includes 3-dimensional cross-point memory, memory that uses chalcogenide phase change material, multi-threshold level NAND flash memory, NOR flash memory, single or multi-level phase change memory (PCM), resistive memory, ovonic memory, nanowire memory, ferroelectric transistor random access memory (FeTRAM), magnetoresistive random access memory (MRAM) memory that incorporates memristor technology, or spin transfer torque MRAM (STT-MRAM).

5. A method comprising:
generating a command responsive to a write request to a memory device (200; 934) of one of the preceding claims, the command including at least one content pattern matching a content pattern stored in a pattern register (203) at the memory device (200; 934), wherein the command comprises a write pattern activate, WPACT, command and the matching content pattern (630) includes large numbers of consecutively repeating bit values of 1 or 0; and
forwarding the WPACT command to the memory device (200; 934) to cause the matching content pattern (630) to be pulled from the pattern register (203) and stored to at least a portion of the memory bit cells of the memory device (200;934).

6. The method of claim 5, comprising:
determining the one or more content patterns based on run-time information for write requests to the memory device (200; 934) over a first time interval.

7. The method of claim 6, comprising:
determine one or more second content patterns based on run-time information for write requests to the memory device (200; 934) over a second time interval; and
forward the one or more second content patterns to the memory device (200; 934) for storage to registers (203) maintained at the memory device (200; 934).

8. The method of claim 5, wherein memory device (200; 934) includes non-volatile memory or volatile memory, wherein the volatile memory includes dynamic random access memory (DRAM) and the non-volatile memory includes 3-dimensional cross-point memory, memory that uses chalcogenide phase change material, multi-threshold level NAND flash memory, NOR flash memory, single or multi-level phase change memory (PCM), resistive memory, ovonic memory, nanowire memory, ferroelectric transistor random access memory (FeTRAM), magnetoresistive random access memory (MRAM) memory that incorporates memristor technology, or spin transfer torque MRAM (STT-MRAM).

9. At least one machine readable medium comprising a plurality of instructions that in response to being executed by a system cause the system to carry out a method according to any one of claims 5 to 8.

## Patentansprüche

1. Speichervorrichtung, die Folgendes umfasst:
ein Array von Speicher-Bitzellen, die in einer zweidimensionalen Weise organisiert sind, wobei das Array von Speicher-Bitzellen in Bänke unterteilt ist;
ein Musterregister (203); und
einen Controller für die Speichervorrichtung (200; 934), der eine Logik (210; 622-2) aufweist, von der zumindest ein Teil Hardware aufweist, wobei die Logik (210; 622-2) für Folgendes ausgebildet ist:
Erzeugen eines Befehls als Reaktion auf eine Schreibanforderung an die Speichervorrichtung (200; 934), die mindestens ein Inhaltsmuster aufweist, das mit einem im Musterregister (203) an der Speichervorrichtung (200; 934) gespeicherten Inhaltsmuster übereinstimmt, wobei der Befehl einen Schreibmusteraktivierungs-(WPACT)-Befehl umfasst und das übereinstimmende Inhaltsmuster (630) eine große Anzahl von sich fortlaufend wiederholenden Bitwerten von 1 oder 0 aufweist; und
Weiterleiten des WPACT-Befehls an die Speichervorrichtung (200; 934), um zu veranlassen, dass das übereinstimmende Inhaltsmuster (630) aus dem Musterregister (203) gezogen und in mindestens einem Teil der Speicher-Bitzellen der Speichervorrichtung (200; 934) gespeichert wird.

2. Speichervorrichtung nach Anspruch 1, wobei die Logik (210; 622-2) ferner für Folgendes ausgebildet ist: Bestimmen des einen oder mehrerer Inhaltsmuster basierend auf Laufzeitinformationen für Schreibanforderungen an die Speichervorrichtung (200; 934) über ein erstes Zeitintervall.

3. Speichervorrichtung nach Anspruch 2, wobei die Logik (210; 622-2) ferner für Folgendes ausgebildet ist: Bestimmen eines oder mehrerer zweiter Inhaltsmuster basierend auf Laufzeitinformationen für Schreibanforderungen an die Speichervorrichtung (200; 934) über ein zweites Zeitintervall; und
Weiterleiten des einen oder der mehreren zweiten Inhaltsmuster an die Speichervorrichtung (200; 934) zur Speicherung in Registern (203), die in der Speichervorrichtung (200; 934) geführt werden.

4. Speichervorrichtung nach Anspruch 1, wobei die Speichervorrichtung (200; 934) einen nichtflüchtigen Speicher oder einen flüchtigen Speicher aufweist, wobei der flüchtige Speicher einen dynamischen Direktzugriffsspeicher (DRAM) aufweist und der nichtflüchtige Speicher einen dreidimensionalen Kreuzpunktspeicher aufweist, einen Speicher, der ein Chalkogenid-Phasenänderungsmaterial verwendet, einen NAND-Flash-Speicher mit mehreren Schwellenwerten, einen NOR-Flash-Speicher, einen Ein- oder Mehrebenen-Phasenänderungsspeicher (PCM), einen Resistivspeicher, einen Ovonspeicher, einen Nanodrahtspeicher, einen ferroelektrischen Transistor-Direktzugriffsspeicher (FeTRAM), einen magnetoresistiven Direktzugriffsspeicher (MRAM), der die Memristor-Technologie beinhaltet, oder Spin-Transfer-Torque-MRAM (STT-MRAM).

5. Verfahren, das Folgendes umfasst:
Erzeugen eines Befehls als Reaktion auf eine Schreibanforderung an die Speichervorrichtung (200; 934) nach einem der vorhergehenden Ansprüche, wobei der Befehl mindestens ein Inhaltsmuster aufweist, das mit einem im Musterregister (203) an der Speichervorrichtung (200; 934) gespeicherten Inhaltsmuster übereinstimmt, wobei der Befehl einen Schreibmusteraktivierungs-(WPACT)-Befehl umfasst und das übereinstimmende Inhaltsmuster (630) eine große Anzahl von sich fortlaufend wiederholenden Bitwerten von 1 oder 0 aufweist; und
Weiterleiten des WPACT-Befehls an die Speichervorrichtung (200; 934), um zu veranlassen, dass das übereinstimmende Inhaltsmuster (630) aus dem Musterregister (203) gezogen und in mindestens einem Teil der Speicher-Bitzellen der Speichervorrichtung (200; 934) gespeichert wird.

6. Verfahren nach Anspruch 5, das Folgendes umfasst: Bestimmen des einen oder mehrerer Inhaltsmuster basierend auf Laufzeitinformationen für Schreibanforderungen an die Speichervorrichtung (200; 934) über ein erstes Zeitintervall.

7. Verfahren nach Anspruch 6, das Folgendes umfasst: Bestimmen eines oder mehrerer zweiter Inhaltsmuster basierend auf Laufzeitinformationen für Schreibanforderungen an die Speichervorrichtung (200; 934) über ein zweites Zeitintervall; und
Weiterleiten des einen oder der mehreren zweiten Inhaltsmuster an die Speichervorrichtung (200; 934) zur Speicherung in Registern (203), die in der Speichervorrichtung (200; 934) geführt werden.

8. Verfahren nach Anspruch 5, wobei die Speichervorrichtung (200; 934) einen nichtflüchtigen Speicher oder einen flüchtigen Speicher aufweist, wobei der flüchtige Speicher einen dynamischen Direktzugriffsspeicher (DRAM) aufweist und der nichtflüchtige Speicher einen dreidimensionalen Kreuzpunktspeicher aufweist, einen Speicher, der ein Chalkogenid-Phasenänderungsmaterial verwendet, einen NAND-Flash-Speicher mit mehreren Schwellenwerten, einen NOR-Flash-Speicher, einen Ein- oder Mehrebenen-Phasenänderungsspeicher (PCM), einen Resistivspeicher, einen Ovonspeicher, einen Nanodrahtspeicher, einen ferroelektrischen Transistor-Direktzugriffsspeicher (FeTRAM), einen magnetoresistiven Direktzugriffsspeicher (MRAM), der die Memristor-Technologie beinhaltet, oder Spin-Transfer-Torque-MRAM (STT-MRAM).

9. Mindestens ein maschinenlesbares Medium, das eine Vielzahl von Anweisungen aufweist, die als Reaktion darauf, dass sie von einem System ausgeführt werden, das System veranlassen, ein Verfahren gemäß einem der Ansprüche 5 bis 8 auszuführen.

## Revendications

1. Dispositif de mémoire, comprenant :
un réseau de cellules binaires de mémoire organisées de manière bidimensionnelle, le réseau de cellules binaires de mémoire étant divisé en bancs ;
un registre de schémas (203) ; et
un contrôleur pour le dispositif de mémoire (200 ; 934) qui comporte une logique (210 ; 622-2) dont au moins une partie comprend du matériel, la logique (210 ; 622-2) étant configurée pour :
générer une commande en réponse à une demande d'écriture dans le dispositif de mémoire (200 ; 934) qui comporte au moins un schéma de contenu concordant avec un schéma de contenu enregistré dans le registre de schémas (203) au niveau du dispositif de mémoire (200 ; 934), la commande comprenant une commande d'activation de motif d'écriture, notée WPACT, et le motif de contenu concordant (630) comportant des grands nombres de valeurs binaires de 1 ou de 0 se répétant consécutivement ; et
retransmettre la commande WPACT au dispositif de mémoire (200 ; 934) pour provoquer l'extraction du schéma de contenu concordant (630) du registre de schémas (203) et son enregistrement dans au moins une partie des cellules binaires de mémoire du dispositif de mémoire (200 ; 934).

2. Dispositif de mémoire selon la revendication 1, dans lequel la logique (210 ; 622-2) est configurée en outre pour :
déterminer les un ou plusieurs schémas de contenu sur la base d'informations d'exécution pour des demandes d'écriture dans le dispositif de mémoire (200 ; 934) sur un premier intervalle de temps.

3. Dispositif de mémoire selon la revendication 2, dans lequel la logique (210 ; 622-2) est configurée en outre pour :
déterminer un ou plusieurs deuxièmes schémas de contenu sur la base d'informations d'exécution pour des demandes d'écriture dans le dispositif de mémoire (200 ; 934) sur un deuxième intervalle de temps ; et
retransmettre les un ou plusieurs deuxièmes schémas de contenu au dispositif de mémoire (200 ; 934) pour enregistrement dans des registres (203) tenus au niveau du dispositif de mémoire (200 ; 934).

4. Dispositif de mémoire selon la revendication 1, lequel dispositif de mémoire (200 ; 934) comporte une mémoire non volatile ou une mémoire volatile, la mémoire volatile comportant une mémoire vive dynamique (DRAM) et la mémoire non volatile comportant une mémoire à points de croisement tridimensionnelle, une mémoire faisant appel à un matériau à changement de phase à base de chalcogénures, une mémoire flash NON-ET à niveaux de seuil multiples, une mémoire flash NON-OU, une mémoire à changement de phase (PCM) à un seul niveau ou à niveaux multiples, une mémoire résistive, une mémoire ovonique, une mémoire à nanofils, une mémoire vive à transistors ferroélectriques (FeTRAM), une mémoire de type mémoire vive magnétorésistive (MRAM) qui incorpore la technologie des memristors, ou une MRAM à écriture par couple de transfert de spin (STT-MRAM).

5. Procédé, comprenant :
la génération d'une commande en réponse à une demande d'écriture dans un dispositif de mémoire (200 ; 934) selon l'une des revendications précédentes, la commande comportant au moins un schéma de contenu concordant avec un schéma de contenu enregistré dans un registre de schémas (203) au niveau du dispositif de mémoire (200 ; 934), la commande comprenant une commande d'activation de motif d'écriture, notée WPACT, et le motif de contenu concordant (630) comportant des grands nombres de valeurs binaires de 1 ou de 0 se répétant consécutivement ; et
la retransmission de la commande WPACT au dispositif de mémoire (200 ; 934) pour provoquer l'extraction du schéma de contenu concordant (630) du registre de schémas (203) et son enregistrement dans au moins une partie des cellules binaires de mémoire du dispositif de mémoire (200 ; 934).

6. Procédé selon la revendication 5, comprenant :
la détermination des un ou plusieurs schémas de contenu sur la base d'informations d'exécution pour des demandes d'écriture dans le dispositif de mémoire (200 ; 934) sur un premier intervalle de temps.

7. Procédé selon la revendication 6, comprenant :
la détermination d'un ou plusieurs deuxièmes schémas de contenu sur la base d'informations d'exécution pour des demandes d'écriture dans le dispositif de mémoire (200 ; 934) sur un deuxième intervalle de temps ; et
la retransmission des un ou plusieurs deuxièmes schémas de contenu au dispositif de mémoire (200 ; 934) pour enregistrement dans des registres (203) tenus au niveau du dispositif de mémoire (200 ; 934).

8. Procédé selon la revendication 5, dans lequel le dispositif de mémoire (200 ; 934) comporte une mémoire non volatile ou une mémoire volatile, la mémoire volatile comportant une mémoire vive dynamique (DRAM) et la mémoire non volatile comportant une mémoire à points de croisement tridimensionnelle, une mémoire faisant appel à un matériau à changement de phase à base de chalcogénures, une mémoire flash NON-ET à niveaux de seuil multiples, une mémoire flash NON-OU, une mémoire à changement de phase (PCM) à un seul niveau ou à niveaux multiples, une mémoire résistive, une mémoire ovonique, une mémoire à nanofils, une mémoire vive à transistors ferroélectriques (FeTRAM), une mémoire de type mémoire vive magnétorésistive (MRAM) qui incorpore la technologie des memristors, ou une MRAM à écriture par couple de transfert de spin (STT-MRAM).

9. Support(s) lisible(s) par machine comprenant une pluralité d'instructions qui, suite à leur exécution par un système, amènent le système à accomplir un procédé selon l'une quelconque des revendications 5 à 8.
